# EUROPÄISCHE PATENTSCHRIFT

(11) **EP 2 589 274 B1**
(45) Veröffentlichungstag und Bekanntmachung des Hinweises auf die Patenterteilung: **04.06.2014**
(21) Anmeldenummer: 11723063.1
(22) Anmeldetag: 01.06.2011
(51) Int. Cl.: H05K 5/06, H05K 5/00

(54) **STEUERGERÄTBAUGRUPPE**
CONTROL DEVICE ASSEMBLY
MODULE D'APPAREIL DE COMMANDE

(30) Priorität: 02.07.2010 DE 102010030891
(43) Veröffentlichungstag der Anmeldung: 08.05.2013
(73) Patentinhaber: ZF Friedrichshafen AG, 88038 Friedrichshafen (DE)
(72) Erfinder: DITTRICH, Jörg, 92260 Ammerthal (DE); WALLNER, Herbert, 91275 Auerbach (DE); ROBIN, Hermann, Josef, 93053 Regensburg (DE); LOIBL, Josef, 93077 Bad Abbach (DE)
(86) Internationale Anmeldenummer: PCT/EP2011/059099
(87) Internationale Veröffentlichungsnummer: WO 2012/000736

(56) Entgegenhaltungen:
- WO-A1-2006/077208
- DE-A1- 3 933 084
- DE-A1-102007 029 913
- DE-A1-102007 038 331

## Beschreibung

Die vorliegende Erfindung betrifft eine Steuergerätbaugruppe gemäß dem Oberbegriff von Anspruch 1.

Steuergeräte im Stand der Technik, insbesondere solche zur Verwendung im Kraftfahrzeug, z.B. Getriebesteuergeräte oder Motorsteuergeräte, weisen in der Regel ein Gehäuse auf, um die Steuergerätelektronik vor Umwelteinflüssen zu schützen. Das Gehäuse umfängt die elektronischen Komponenten bzw. kapselt diese unter Verwendung einer oder mehrerer Dichtungen mediendicht ein.

Steuergeräte, welche mittels einer starren Leiterplatte gebildet sind, welche aus dem Gehäuse zu Ankontaktierzwecken z.B. hervorragt, sind im Allgemeinen mittels eines Gehäuses aus Gehäuseoberteil und z.B. Gehäuseunterteil gebildet. Bei einer bekannten Variante wird als Gehäuseoberteil und als Gehäuseunterteil jeweils ein Druckgussteil verwendet, zwischen welchen die Leiterplatte angeordnet ist. In den jeweiligen Druckgussteilen ist jeweils eine umlaufende Nut gebildet, in welche eine Dichtung eingesetzt wird, um gegen die Leiterplatte zur Abdichtung zur Anlage zu gelangen. Solche Druckgussteile sind jedoch teuer in der Herstellung.

Bei einer weiteren bekannten Variante wird als Gehäuseoberteil z.B. ein Aluminiumblech verwendet, welches komplex umgeformt wird, um eine Aufnahmenut für eine Dichtung sowie den nötigen Hohlraum zur Deckelung der zu kapselnden Bauteile zu bilden. Das Gehäuseunterteil besteht wie vor aus einem Aluminiumdruckgussteil. Das Gehäuseoberteil ist hierbei zwar günstiger herzustellen als ein Aludruckgussoberteil, aber durch seine komplexe Form noch immer kostenintensiv.

Aus der Druckschrift DE 39 33 084 A1 ist ein Gehäuse für eine Steuergerätelektronik bekannt, bei welcher ein Kühlrahmen vorgesehen ist, an welchem Gehäuseober- und Unterteil sowie eine einseitig bestückte Leiterplatte angeordnet sind. Nachteilig ist wiederum, dass komplexe Umformprozesse zur Bildung einer die Dichtung aufnehmenden Nut sowie des Kühlrahmens erforderlich sind.

DE 10 2007 038331 A1 offenbart eine Steuergerätbaugruppe, bei welcher an einer bestückten Seite einer Leiterplatte eine Klebefolie vorhanden ist, mittels welcher der Gehäusedeckel mit der Leiterplatte verklebt wird.

DE 10 2007 029913 A1 beschreibt ein elektronisches Steuergerät zum Einbau in den Motorraum eines Fahrzeugs, mit einem die Steuergerätelektronik aufnehmenden Leiterbahnsubstrat, wobei ein Dichtring von Gehäuseteilen gegen das Leiterbahnsubstrat gedrängt sind.

Ausgehend hiervon liegt der vorliegenden Erfindung die Aufgabe zugrunde, vorstehend geschilderte Nachteile des Standes der Technik zu überwinden und eine Steuergerätbaugruppe vorzuschlagen, welche eine einfache und kostengünstige Einhäusung und Abdichtung der Steuergerätelektronik ermöglicht.

Diese Aufgabe wird erfindungsgemäß durch die Merkmale des Anspruchs 1 gelöst.

Vorgeschlagen wird erfindungsgemäß eine Steuergerätbaugruppe, insbesondere für ein Kraftfahrzeug, mit einer die Steuergerätelektronik aufnehmenden Leiterplatte, dadurch gekennzeichnet, dass an einer bestückten Seite der Leiterplatte wenigstens ein eigenständig gebildetes Rahmenelement wenigstens ein elektronisches Bauelement einfassend abgestützt ist, wobei gegen eine äußere Umfangsfläche des Rahmenelements eine diese umfangende Dichtung anliegt, und wobei die Dichtung von einem Gehäuseelement zur Bildung eines mediendicht abgedichteten Elektronikraumes gegen die Leiterplatte gedrängt ist.

Bei einer erfindungsgemäßen Ausführungsform der Steuergerätbaugruppe ist das Rahmenelement separat von dem Gehäuseelement, welches insbesondere ein Gehäuseoberteil oder ein Gehäuseunterteil ist, und der Leiterplatte gebildet.

Bei einer weiteren erfindungsgemäßen Ausführungsform der Steuergerätbaugruppe ist das Rahmenelement dauerhaft an der Leiterplatte angeordnet, insbesondere in die Leiterplatte gesteckt.

Bei noch einer weiteren erfindungsgemäßen Ausführungsform der Steuergerätbaugruppe ist das Rahmenelement aus Kunststoff oder aus einem Blech gefertigt.

Gemäß einem Aspekt der erfindungsgemäßen Steuergerätbaugruppe ist das Rahmenelement an dem Gehäuseelement dauerhaft befestigt, insbesondere darin eingesetzt.

Gemäß einem weiteren Aspekt der erfindungsgemäßen Steuergerätbaugruppe ist das Gehäuseelement plattenförmig gebildet, insbesondere als ebene Platte.

Gemäß noch einem weiteren Aspekt der erfindungsgemäßen Steuergerätbaugruppe ist die Leiterplatte mit dem Rahmenelement thermisch leitend verbunden und das Rahmenelement mit dem Gehäuseelement thermisch leitend verbunden.

Vorgeschlagen wird erfindungsgemäß auch eine Steuergerätbaugruppe, wobei das Profil des Rahmenelements zwischen der Leiterplatte und dem Gehäuseelement rechteckförmig ist.

Vorgeschlagen wird erfindungsgemäß weiterhin eine Steuergerätbaugruppe, wobei an einer ersten und einer gegenüberliegenden zweiten Seite der Leiterplatte jeweils ein Rahmenelement mit einer dieses umfangenden Dichtung wenigstens ein elektronisches Bauelement einfassend angeordnet ist, wobei jeweils die Dichtung von einem Gehäuseelement gegen die Leiterplatte gedrängt ist, derart, dass ein erster und ein zweiter mediendicht abgedichteter Elektronikraum gebildet ist.

Bei einer erfindungsgemäßen Ausführungsform der Steuergerätbaugruppe ist an einem Gehäuseelement der Steuergerätbaugruppe wenigstens eine Lasche zur dauerhaften Verbindung mit einem weiteren Gehäuseelement angeordnet.

Weitere Merkmale und Vorteile der Erfindung ergeben sich aus der nachfolgenden Beschreibung von Ausführungsbeispielen der Erfindung, anhand der Figuren der Zeichnungen, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Bevorzugte Ausführungsformen der Erfindung werden nachfolgend anhand der beigefügten Zeichnungen näher erläutert. Es zeigen:
- Fig. 1: exemplarisch eine Steuergerätbaugruppe ohne Gehäuseoberteil gemäß einer möglichen Ausführungsform der Erfindung;
- Fig. 2: exemplarisch eine abgebrochene Schnittansicht einer Steuergerätbaugruppe gemäß einer möglichen Ausführungsform der Erfindung;
- Fig. 3: exemplarisch ein Gehäuseelement einer Steuergerätbaugruppe gemäß einer weiteren möglichen Ausführungsform der Erfindung; und
- Fig. 4: exemplarisch eine abgebrochene Schnittansicht einer Steuergerätbaugruppe gemäß der weiteren möglichen Ausführungsform der Erfindung.

In den nachfolgenden Figurenbeschreibungen sind gleiche Elemente bzw. Funktionen mit gleichen Bezugszeichen versehen.

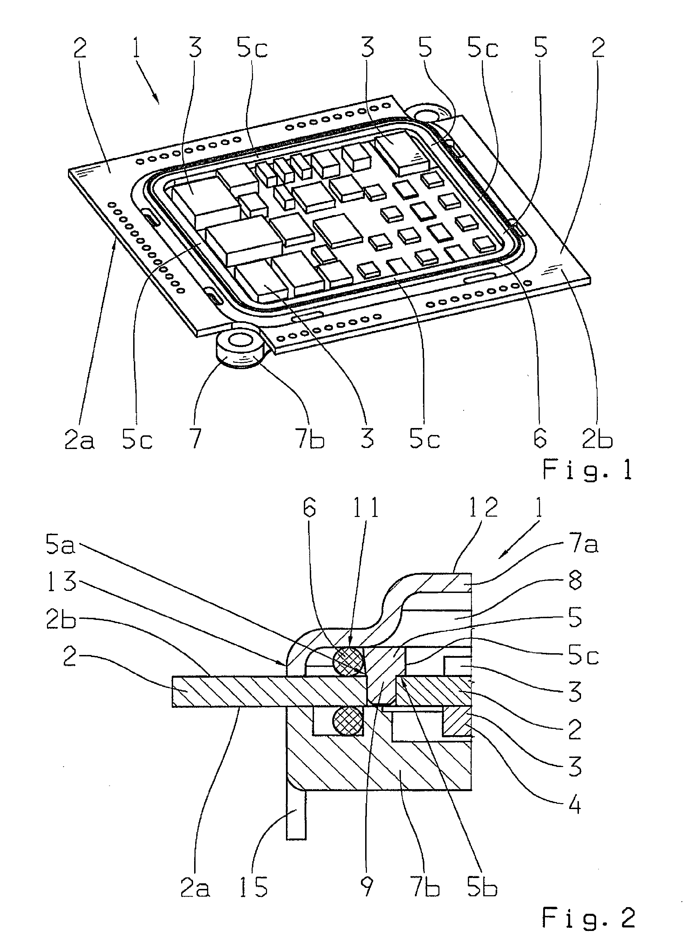

Die Fig. 1 zeigt exemplarisch eine Steuergerätbaugruppe 1 gemäß der Erfindung mit abgenommenem Gehäuseelement, vorliegend abgenommenem Gehäuseoberteil. Die Steuergerätbaugruppe 1 weist eine Leiterplatte 2 auf, an welcher elektronische Bauelemente bzw. Komponenten 3 einer Steuergerätschaltung, insbesondere die Steuergerätelektronik aufgenommen bzw. ausgebildet ist. Die elektronischen Bauelemente 3 umfassen z.B. einen Mikrocontroller und/oder Prozessor, Transistoren und z.B. weitere Leistungsbauelemente, etc. Das mittels der Steuergerätelektronik gebildete Steuergerät ist z.B. ein Getriebesteuergerät oder ein Motorsteuergerät, i.e. ein Steuergerät für ein Kraftfahrzeug.

Die Leiterplatte 2 ist erfindungsgemäß in Form einer starren Leiterplatte gebildet, z.B. einer Epoxidharz- oder FR4-Leiterplatte, insbesondere einer mehrlagigen bzw. Multilayer-Leiterplatte. Vorzugsweise ist die Leiterplatte 2 z.B. eine HDI-Leiterplatte, bei welcher ein vorteilhaft hoher Integrationsgrad der Bauelemente 3 erzielbar ist. Zur Vernetzung der elektronischen Komponenten 3 sind an der Leiterplatte 2 Leiterbahnen und z.B. Durchkontaktierungen bzw. Vias gebildet. Die Leiterplatte 2 ist einseitig oder vorzugsweise beidseitig bestückt. Z.B. ist an der ersten Seite 2a der Leiterplatte 2, z.B. einer Unterseite, ein Mikrocontroller 4 angeordnet, während weitere Bauelemente 3 z.B. an der gegenüberliegenden zweiten Seite 2b, z.B. einer Oberseite, angeordnet sind.

Erfindungsgemäß ist an der Leiterplatte 2 ein Rahmen bzw. ein Rahmenelement 5 angeordnet bzw. abgestützt, z.B. an der bestückten ersten Seite 2b, welches eigenständig gebildet ist, d.h. in einem gesonderten Fertigungsprozess gefertigt. Das Rahmenelement 5 ist z.B. aus Kunststoff gebildet oder z.B. aus einem Blech und dazu vorgesehen, eine Abstützung zur Führung einer Gehäusedichtung 6 auszubilden, welche zur Abdichtung u.a. mit einem Gehäuseelement 7a, insbesondere einem deckelnden Gehäuseelement 7a, zusammenwirkt. Mittels einer solchen Anordnung kann ein geschützter Elektronikraum 8 für die elektronischen Komponenten 3 gebildet werden, i.e. ein mediendichter Elektronikraum 8.

Das erfindungsgemäße Rahmenelement 5 umfängt wenigstens ein an der bestückten Leiterplattenseite 2b aufgenommenes elektronisches Bauelement 3, vorzugsweise mehrere oder sämtliche derartigen Bauelemente 3, i.e. als Gruppe, bzw. fasst diese ein bzw. umrahmt diese. Das Rahmenelement 5 ist dazu vorzugsweise als ununterbrochener Rahmen ausgebildet, kann jedoch ggf. auch segmentiert sein. Die vor insbesondere schädigenden Einflüssen zu schützenden Bauelemente 3 sind als Gruppe von den einen Rahmen 5 bildenden Rahmenstegen 5c umfangen, Fig. 1, welche z.B. integral gebildet sind.

Um eine Dichtung 6, welche zur Anlage an der Außenumfangsfläche 5a des Rahmenelements 5 diese(s) umfangend vorgesehen ist, geeignet abstützen und um die mit dem Gehäuseelement 7a einzuhäusenden Bauelemente 3 herum führen zu können, ist das Rahmenelement 5 an der Leiterplatte 2 abgestützt, z.B., wie in Fig. 1 und 2 gezeigt, darin positionstreu eingesteckt. Das Rahmenelement 5 weist dazu entsprechende Befestigungsvorsprünge 9 auf, welche aus einer zur Abstützung an der Leiterplatte 2 vorgesehenen Anlagefläche 5b des Rahmenelements 5 hervorragen und in korrespondierende Aussparungen 10 der Leiterplatte 2 eingreifen, z.B. durch Presssitz. Andere Befestigungsmöglichkeiten für das Rahmenelement 5 an der Leiterplatte 2 sind daneben denkbar, z.B. Klebung, Verschraubung, Verschweißen, oder weitere.

Das Rahmenelement 5 weist z.B. rechteckige Form auf, i.e. Rahmenform, wobei die Ecken der Rahmenform z.B. abgerundet sind, Fig. 1. Im Profil bzw. im Querschnitt durch einen Rahmensteg 5c weist das Rahmenelement 5 mit Ausnahme der nach unten bzw. in die Leiterplatte 2 ragenden Steckverbindungs-Vorsprünge 9 z.B. ebenfalls rechteckige Form auf, z.B. Fig. 2. Als Rahmenform kommen jedoch auch andere Formen in Frage.

Das Rahmenelement 5 ist innerhalb des Umrisses der Leiterplatte 2 dauerhaft angeordnet, so dass sich die Leiterplatte 2 über das Rahmenelement 5 hinaus erstreckt und eine elektrische Ankontaktierung auf einfache Weise ermöglicht ist, z.B. durch Pressfit-Pins, Stanzgitter, etc.

Zur Abdichtung bzw. Schaffung eines mediendichten Elektronikraumes 8 ist, wie bereits erwähnt, eine Dichtung 6, z.B. eine ringförmige Dichtung oder Formdichtung, insbesondere eine elastische Dichtung, gegen die äußere bzw. Außenumfangsfläche 5a des eigenständig gebildeten und an der Leiterplatte 2 abgestützten Rahmenelements 5 zur Anlage gebracht, Fig. 2. Die Dichtung 6 ist um das Rahmenelement 5 herum bzw. dieses umfangend angeordnet. Durch das die Dichtung 6 durchgreifende Rahmenelement 5 wird die Dichtung 6 abgestützt bzw. positionstreu fixiert. Die Dichtung 6 liegt an der Leiterplatte 2 an, i.e. an der Seite 2b der Leiterplatte 2, an welcher das Rahmenelement 5 aufliegend angeordnet ist, Fig. 2.

Zur Bildung eines geschützten Elektronikraumes 8 bzw. eines Gehäuses für wenigstens ein an der bestückten Leiterplattenseite 2b angeordnetes elektronisches Bauelement 3, ist ein deckelndes bzw. einen Deckel bildendes Gehäuseelement 7a, z.B. ein Gehäuseoberteil, an der Leiterplatte 2 gegen die Dichtung 6 gedrängt angeordnet, derart, dass die Dichtung 6, welche ohne aufliegendes Gehäuseelement 7a das Rahmenelement 5 in Richtung von der Leiterplatte 2 zur Dichtung 6 überragt, komprimiert wird, insbesondere über deren gesamte Länge, und somit verlässlich abdichtet, i.e. zwischen der Leiterplatte 2 und dem deckelnden Gehäuseelement 7a. Durch das an der Dichtung 6 anliegende Gehäuseelement 7a ist die Dichtung 6 gegen die Leiterplatte 2 und gegen die Außenumfangsfläche 5a gedrängt, zum Beispiel zusätzlich zu einer entsprechenden Vorspannung gegen die Außenumfangsfläche 5a.

Das Gehäuseelement 7a, welches erfindungsgemäß z.B. ein Gehäuse-element aus einem umgeformten Blech, z.B. einem Aluminiumblech ist, ist an der Leiterplatte 2 fixiert, z.B. mit einem weiteren deckelnden Gehäuseelement 7b, z.B. einem Gehäuseunterteil, an der gegenüberliegenden Leiterplattenseite 2a verschraubt, verrastet, verschnappt, verspannt, verbördelt, etc. Durch die erfindungsgemäße Anordnung ist eine komplexe Form des Gehäuseelements 7a zur Aufnahme und Fixierung der Dichtung 6 im Gegensatz zum Stand der Technik entbehrlich. Somit kann ein kostengünstiges Gehäuseelement 7a verwendet werden, welches nicht komplex umgeformt werden muss.

Das erfindungsgemäße Gehäuseelement 7a bildet vorteilhaft einen ebenen Auflagebereich 11 zur Anlage an der Dichtung 6 aus, mittels welchem die Dichtung in Eingriff bringbar und somit gefangen ist. Der Auflagebereich 11 korrespondiert mit der Form der um den Rahmen 5 an der Leiterplatte 2 aufliegend angeordneten Dichtung 6 und ist umlaufend am Gehäuseelement 7a gebildet, z.B. als Flanschabschnitt, welcher sich parallel zur Leiterplattenoberfläche 2b erstreckt. Innerhalb des umlaufenden ebenen Auflagebereichs 11 ist z.B. der die Bauelemente 3 deckelnde Bereich 12 des Gehäuseelements 7a gebildet, außerhalb des Auflagebereichs 11 z. B. ein gekröpfter Bereich 13, welcher gegen die Leiterplatte 2 abgestützt ist, so dass die Dichtung 6 vor schädigenden Einflüssen geschützt ist.

In Fig. 2 ist zu sehen, dass eine weitere bestückte Seite 2a z.B. auf herkömmliche Weise mittels eines Aluminiumdruckgussteils 7b deckelbar ist. Alternativ kann die weitere bestückte Seite 2a gemäß der Erfindung mittels eines eigenständig gebildeten Rahmenelements 5 gekapselt und abgedichtet sein, i.e. wie oben für die Leiterplattenseite 2a beschrieben. Z.B. ist je bestückter Leiterplattenseite 2a bzw. 2b ein Rahmenelement 5 vorgesehen, welches wie oben beschrieben mit einer Dichtung 6 und einem zugeordneten Gehäuseelement 7a bzw. 7b zur Bildung eines mediendichten Elektronikraums zusammenwirkt. Das weitere Gehäuseelement 7b ist z.B. ebenfalls aus Aluminiumblech gebildet.

Um eine erfindungsgemäße Steuergerätbaugruppe 1 gemäß der vorstehend geschilderten Ausführungsform zu bilden, wird zunächst das separat gefertigte Rahmenelement 5 bereitgestellt und in einem weiteren Schritt in die Leiterplatte 2 gesteckt bzw. daran dauerhaft angeordnet. In einem anschließenden Schritt wird die Dichtung 6 um das Rahmenelement 5 herum angeordnet und gegen dessen Außenumfangsfläche 5a zur Anlage gebracht. In einem weiteren Schritt wird das Gehäuseelement 7a auf dem Rahmenelement 5 und der Dichtung 6 zur Anlage gebracht und an der Leiterplatte 2 dauerhaft befestigt, wobei die Dichtung 6 gegen die Leiterplatte 2 einerseits und gegen das Gehäuseelement 7a andererseits gedrängt wird. Der Elektronikraum 8 zwischen Leiterplatte 2 und Gehäuseelement 7a wird dabei abgedichtet.

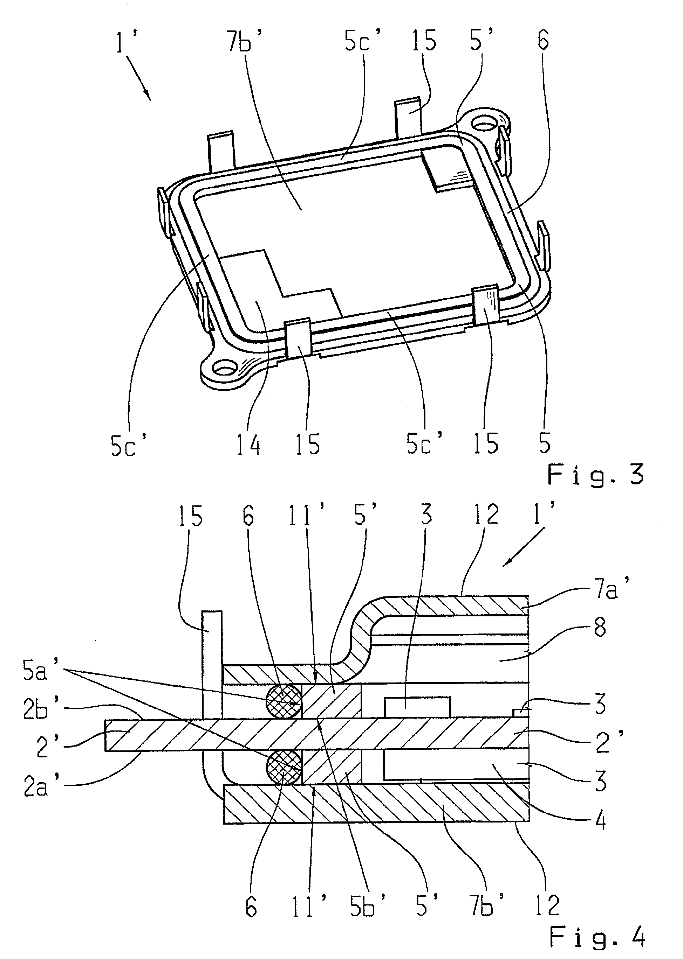

Fig. 3 und 4 zeigen eine weitere erfindungsgemäße Ausführungsform einer Steuergerätbaugruppe 1', wobei Fig. 3 ein Gehäuseelement 7b' mit einem daran angeordneten, eigenständig gebildeten Rahmenelement 5' zeigt. Im Unterschied zur oben beschriebenen Ausführungsform ist bei der weiteren Ausführungsform ein eigenständig gefertigtes bzw. gebildetes Rahmenelement 5' nicht in die Leiterplatte 2 sondern in ein separat gefertigtes Gehäuseelement 7a' bzw. 7b' eingesetzt bzw. daran dauerhaft angeordnet. Das Rahmenelement 5' ist z.B. aus demselben Material gefertigt wie das jeweilige Gehäuseelement 7a', 7b', z.B. aus Aluminium bzw. Aluminiumblech, und kann z.B. durch einfaches Stanzen aus einem Blech gebildet werden. Alternativ kann das Rahmenelement 5' aus einem vom Material des Gehäuseelements 7a' bzw. 7b' verschiedenen Material gebildet sein.

Das Rahmenelement 5' weist wiederum z.B. rechteckige Form auf, wobei die Rahmenstege 5c' z.B. ebenfalls rechteckiges Profil aufweisen. Die Anlagefläche 5b' weist insbesondere keine Befestigungselemente auf, sondern ist z.B. durchgehend eben ausgebildet.

Erfindungsgemäß ist vorgesehen, das Rahmenelement 5' aus Stabilitätsgründen mit dem daran anliegenden Gehäuseelement 7a' bzw. 7b', z.B. einem Gehäuseunterteil 7b' oder einem Gehäuseoberteil 7a', dauerhaft zu verbinden, z.B. durch Kleben oder Verschweißen, etc. Zur Herstellung der gewünschten Funktionalität der Bildung eines abgedichteten Elektronikraums 8 müssen Gehäuseelement 7a' bzw. 7b' und das jeweilige Rahmenelement 5' jedoch nicht zwingend dauerhaft verbunden sein.

Bei der weiteren Ausführungsform wird das Rahmenelement 5' an dem Gehäuseelement 7a' bzw. 7b' jeweils an derjenigen Seite angeordnet, welche dazu vorgesehen ist, die Innenseite eines Deckels für die elektronischen Bauelemente 3 zu bilden. Dazu bildet das Gehäuseelement 7a' bzw. 7b' zum Beispiel jeweils einen umlaufenden ebenen Auflagebereich 11', an welchem das hinsichtlich seiner Form korrespondierende Rahmenelement 5' angeordnet ist und welcher ferner zur Anlage an einer dieses umfangenden Dichtung 6 vorgesehen ist. Das jeweilige Rahmenelement 5' weist dabei eine Abmessung auf, die das Umfangen der zu schützenden Bauelemente 3 sowie eine Abstützung an der Leiterplatte 2' ermöglicht. Die Leiterplatte 2' bildet z.B. keine Befestigungselemente für das Rahmenelement 5' aus, das Gehäuseelement 7a' bzw. 7b' z.B. keinen gekröpften Abschnitt 13.

Eine Dichtung 6 oben beschriebener Ausbildung ist um das jeweilige Rahmenelement 5' herum angeordnet, derart, dass die Dichtung 6 gegen die äußere Umfangsfläche 5a' des Rahmenelements 5' zur Anlage gelangt. Das Gehäuseelement 7a' bzw. 7b' ist wiederum jeweils an der Leiterplatte 2' fixiert, z.B. mit dem weiteren Gehäuseelement 7b' bzw. 7a' an der gegenüberliegenden Leiterplattenseite 2a' bzw. 2b' verschraubt oder verspannt, etc. Die weitere erfindungsgemäße Ausführungsform erlaubt ebenfalls die Verwendung eines kostengünstigen Gehäuseelements 7a' bzw. 7b', welches nicht komplex umgeformt werden muss.

Im Zuge der Anordnung von Rahmenelement 5' und Gehäuseelement 7' an der Leiterplatte 2' wird die Dichtung zwischen Leiterplatte 2' und Gehäuseelement 7' geklemmt und somit eine Abdichtung eines Elektronikraumes 8 erzielt. Dabei ist das Rahmenelement 5' an der Leiterplatte 2' abgestützt.

Erfindungsgemäß ist z.B. vorgesehen, insbesondere im Falle einer beidseitig bestückten Leiterplatte 2', sowohl ein Gehäuseelement 7a', z.B. in Form eines Gehäuseoberteils, als auch ein Gehäuseelement 7b', z.B. in Form eines Gehäuseunterteils, jeweils mit einem erfindungsgemäßen Rahmenelement 5' zu versehen und mit einer dieses umfangenden Dichtung 6 an jeweils einer Seite 2a' bzw. 2b' der Leiterplatte 2' auf oben beschriebene Weise zur Kapselung daran bestückter Bauelemente 3 anzuordnen.

Das Rahmenelement 5' der weiteren Ausführungsform ist ferner z.B. zur Wärmeableitung vorgesehen, insofern z.B. aus einem thermisch gut leitenden Material gefertigt. Insbesondere bei einer beidseitig bestückten Leiterplatte 2', bei welcher keine direkte Anbindung der an einer Leiterplattenseite 2b' bzw. 2a' bestückten Bauelemente 3 mit einer zur anderen Leiterplattenseite 2a' bzw. 2b' benachbarten Wärmesenke bzw. Kühlvorrichtung, welche z.B. zu dem Gehäuseelement 7b' bzw. 7a', benachbart ist, herstellbar ist, ist eine Entwärmung über den Rahmen 5' vorteilhaft. Zur Entwärmung werden z.B. thermische Vias, welche in der Leiterplatte 2' gebildet sind, mit dem an der Leiterplatte 2' abgestützten Rahmen 5' thermisch leitend verbunden, wobei das Rahmenelement 5' wiederum mit dem zur Wärmesenke benachbarten Gehäuseelement 7b' bzw. 7a' thermisch leitend verbunden ist.

Erfindungsgemäß kann das Rahmenelement 5' zusätzlich z.B. ein oder mehrere im Inneren der Rahmenform gebildete flächige Kühlelemente 14 bzw. -fahnen aufweisen, an welche relativ stark Wärme entwickelnde Bauelemente 3 zur Entwärmung über das Rahmenelement 5' und das jeweilig zugeordnete, damit zur Abdichtung zusammenwirkende Gehäuseelement 7a' bzw. 7b' thermisch leitend anbindbar sind, z.B. über thermische Vias. Die Kühlfahnen 14 sind z.B. zusammen mit dem Rahmenelement 5' in einem einzigen Prozessschritt durch Ausstanzen herstellbar. Die Kühlfahnen 14 ragen z.B. in das Innere des Rahmens 5' und überlappen die Leiterplatte 2' in jenen Bereichen, in welchen thermische Vias bzw. zu entwärmende Bauelemente 3 vorgesehen sind.

Erfindungsgemäß ist z.B. vorgesehen, ein Gehäuseelement 7a' bzw. 7b', insbesondere ein Gehäuseunterteil 7b', ohne Umformprozess planar auszubilden, z.B. als gestanztes Blechteil. Ein solches plattenförmiges Gehäuseelement 7a' bzw. 7b' kann vorteilhaft vollflächig aufliegend an einer Wärmesenke in Form z.B. eines Kühlelements zur Anlage gebracht werden. Ferner kann ein solches Gehäuseelement 7 z.B. an einem an der Leiterplatte 2' aufgenommenen IC, z.B. einem Mikrocontroller 4, ggf. unter Zwischenschaltung einer Wärmeleitschicht, zu dessen Entwärmung zur Anlage gebracht werden.

Um Bauraum für hoch bauende Komponenten 3 zu schaffen, kann in einem plattenförmigen bzw. planaren Gehäuseelement 7a' bzw. 7b' z.B. Material auf der dem Bauelement 3 zugewandten Innenseite abgetragen werden, so dass eine Vertiefung gebildet ist, in welche das Bauelement 3 hineinragt.

Um eine erfindungsgemäße Steuergerätbaugruppe 1' gemäß der vorstehend geschilderten weiteren Ausführungsform zu bilden, wird zunächst das separat gefertigte Rahmenelement 5' bereitgestellt und in einem weiteren Schritt in das bereitgestellte Gehäuseelement 7a' bzw. 7b' eingesetzt. In einem optionalen weiteren Schritt wird das Rahmenelement 5' an dem Gehäuseelement 7a' bzw. 7b' dauerhaft befestigt. In einem anschließenden Schritt wird die Dichtung 6 um das Rahmenelement 5' herum angeordnet und gegen dessen Außenumfangsfläche 5a' zur Anlage gebracht. In einem weiteren Schritt wird das Gehäuseelement 7a' bzw. 7b' mit dem Rahmenelement 5' und der Dichtung 6 zur Anlage an der Leiterplatte 2' gebracht und daran dauerhaft befestigt, wobei die Dichtung 6 gegen die Leiterplatte 2' einerseits und gegen das Gehäuseelement 7a' bzw. 7b' andererseits gedrängt wird. Der Elektronikraum 8 zwischen Leiterplatte 2' und Gehäuseelement 7a' bzw. 7b' wird dabei abgedichtet.

Erfindungsgemäß ist allgemein vorgesehen, Gehäuseelement 7a bzw. 7a' und Gehäuseelement 7b bzw. 7b' mittels einer oder mehrerer Laschen 15 kostengünstig durch Umbördeln zu verbinden. Die Laschen 15 werden z.B. integral mit einem oder beiden Gehäuseelementen 7a, 7a', 7b, 7b' gebildet und können bei Bedarf miteinander verschweißt werden, wenn ein robustes und mechanisch festes Gehäuse erforderlich ist.

Vom Gedanken der Erfindung ist auch mit umfasst, ein Rahmenelement 5 der ersten Ausführungsform an einer ersten bestückten Seite 2a oder 2b der Leiterplatte 2 anzuordnen und ein Rahmenelement 5' der zweiten Ausführungsform an einer zweiten bestückten Seite 2b bzw. 2a der Leiterplatte 2. Erfindungsgemäß sind je bestückter Leiterplattenseite 2a, 2a' bzw. 2b, 2b' z.B. auch mehrere Rahmenelemente 5 bzw. 5' denkbar, welche wie oben beschrieben jeweils mit einer Dichtung 6 und einem jeweils zugeordneten Gehäuseelement 7a bzw. 7a' oder 7b bzw. 7b' jeweils zur Bildung eines mediendichten Elektronikraums 8 zusammenwirken.

Durch die Erfindung können vorteilhaft dickere Bleche zur Herstellung von Gehäuseelementen 7a, 7a', 7b, 7b' genutzt werden, insofern als keine komplexe Umformung notwendig ist. Eine bessere Wärmeableitung ist somit erzielbar.

### Bezugszeichen

- 1, 1': Steuergerätbaugruppe
- 2, 2': Leiterplatte
- 2a, 2a': Unterseite Leiterplatte
- 2b, 2b': Oberseite Leiterplatte
- 3: elektronisches Bauelement
- 4: Mikrocontroller
- 5, 5': Rahmenelement
- 5a, 5a': Außenumfangsfläche Rahmenelement
- 5b, 5b': Anlagefläche
- 5c, 5c': Rahmensteg
- 6: Dichtung
- 7a, 7a': Gehäuseelement (Gehäuseoberteil)
- 7b, 7b': Gehäuseelement (Gehäuseunterteil)
- 8: Elektronikraum
- 9: Vorsprung
- 10: Aussparung
- 11, 11': Auflagebereich
- 12: deckelnder Bereich
- 13: gekröpfter Bereich
- 14: Kühlfahne
- 15: Lasche

## Patentansprüche

1. Steuergerätbaugruppe (1; 1'), insbesondere für ein Kraftfahrzeug, mit einer die Steuergerätelektronik aufnehmenden Leiterplatte (2; 2'), **dadurch gekennzeichnet, dass** an einer bestückten Seite (2a; 2a'; 2b; 2b') der Leiterplatte (2; 2') wenigstens ein eigenständig gebildetes Rahmenelement (5; 5') wenigstens ein elektronisches Bauelement (3) einfassend abgestützt ist, wobei gegen eine äußere Umfangsfläche (5a; 5a') des Rahmenelements (5; 5') eine diese umfangende Dichtung (6) anliegt, und wobei die Dichtung (6) von einem Gehäuseelement (7a, 7b; 7a', 7b') zur Bildung eines mediendicht abgedichteten Elektronikraumes (8) gegen die Leiterplatte (2; 2') gedrängt ist.

2. Steuergerätbaugruppe (1; 1') nach Anspruch 1, **dadurch gekennzeichnet, dass** das Rahmenelement (5; 5') separat von dem Gehäuseelement (7a; 7b; 7a', 7b'), welches insbesondere ein Gehäuseoberteil (7a; 7a') oder ein Gehäuseunterteil (7b; 7b') ist, und der Leiterplatte (2; 2') gebildet ist.

3. Steuergerätbaugruppe (1) nach einem der vorhergehenden Ansprüche, **dadurch gekennzeichnet, dass** das Rahmenelement (5) dauerhaft an der Leiterplatte (2) angeordnet ist, insbesondere in die Leiterplatte (2) gesteckt ist.

4. Steuergerätbaugruppe (1; 1') nach einem der vorhergehenden Ansprüche, **dadurch gekennzeichnet, dass** das Rahmenelement (5; 5') aus Kunststoff oder aus einem Blech gefertigt ist.

5. Steuergerätbaugruppe (1') nach einem der vorhergehenden Ansprüche, **dadurch gekennzeichnet, dass** das Rahmenelement (5') an dem Gehäuseelement (7a', 7b') dauerhaft befestigt, insbesondere darin eingesetzt, ist.

6. Steuergerätbaugruppe (1; 1') nach einem der vorhergehenden Ansprüche, **dadurch gekennzeichnet, dass** das Gehäuseelement (7a, 7b; 7a', 7b') plattenförmig gebildet ist, insbesondere als ebene Platte.

7. Steuergerätbaugruppe (1') nach einem der vorhergehenden Ansprüche, **dadurch gekennzeichnet, dass** die Leiterplatte (2') mit dem Rahmenelement (5') thermisch leitend verbunden ist und das Rahmenelement (5') mit dem Gehäuseelement (7a', 7b') thermisch leitend verbunden ist.

8. Steuergerätbaugruppe (1) nach einem der vorhergehenden Ansprüche, **dadurch gekennzeichnet, dass** das Profil des Rahmenelements (5, 5') zwischen der Leiterplatte (2; 2') und dem Gehäuseelement (7a, 7b; 7a', 7b') rechteckförmig ist.

9. Steuergerätbaugruppe (1) nach einem der vorhergehenden Ansprüche, **dadurch gekennzeichnet, dass** an einer ersten (2a; 2a') und einer gegenüberliegenden zweiten (2b; 2b') Seite der Leiterplatte (2, 2') jeweils ein Rahmenelement (5; 5') mit einer dieses umfangenden Dichtung (6) wenigstens ein elektronisches Bauelement (3) einfassend angeordnet ist, wobei jeweils die Dichtung (6) von einem Gehäuseelement (7a, 7b; 7a', 7b') gegen die Leiterplatte (2; 2') gedrängt ist, derart, dass ein erster und ein zweiter mediendicht abgedichteter Elektronikraum (8) gebildet ist.

10. Steuergerätbaugruppe (1; 1') nach einem der vorhergehenden Ansprüche, **dadurch gekennzeichnet, dass** an einem Gehäuseelement (7a, 7b; 7a', 7b') der Steuergerätbaugruppe (1; 1') wenigstens eine Lasche (15) zur dauerhaften Verbindung mit einem weiteren Gehäuseelement (7b, 7a; 7b', 7a') angeordnet ist.

## Claims

1. Control device assembly (1; 1'), in particular for a motor vehicle, with a circuit board (2; 2') receiving the control device electronics, **characterized in that**, on a populated side (2a; 2a'; 2b; 2b') of the circuit board (2; 2'), at least one independently formed frame element (5; 5') is supported so as to border at least one electronic component (3), a seal (6) bearing against an outer circumferential surface (5a; 5a') of the frame element (5; 5') and surrounding the said outer circumferential surface, and the seal (6) being forced by a housing element (7a, 7b; 7a', 7b') against the circuit board (2; 2') to form an electronics space (8) sealed off in a media-tight manner.

2. Control device assembly (1; 1') according to Claim 1, **characterized in that** the frame element (5; 5') is formed separately from the housing element (7a; 7b; 7a', 7b'), which is, in particular, a housing top part (7a; 7a') or a housing bottom part (7b; 7b'), and from the circuit board (2; 2').

3. Control device assembly (1) according to one of the preceding claims, **characterized in that** the frame element (5) is arranged permanently on the circuit board (2), in particular is plugged into the circuit board (2).

4. Control device assembly (1; 1') according to one of the preceding claims, **characterized in that** the frame element (5; 5') is made from plastic or from a metal sheet.

5. Control device assembly (1') according to one of the preceding claims, **characterized in that** the frame element (5') is fastened permanently to the housing element (7a', 7b'), in particular is inserted therein.

6. Control device assembly (1; 1') according to one of the preceding claims, **characterized in that** the housing element (7a, 7b; 7a', 7b') is of plate-shaped form, in particular is formed as a planar plate.

7. Control device assembly (1') according to one of the preceding claims, **characterized in that** the circuit board (2') is connected to the frame element (5') in a thermally conductive manner, and the frame element (5') is connected to the housing element (7a', 7b') in a thermally conductive manner.

8. Control device assembly (1) according to one of the preceding claims, **characterized in that** the profile of the frame element (5, 5') between the circuit board (2; 2') and the housing element (7a, 7b; 7a', 7b') is rectangular.

9. Control device assembly (1) according to one of the preceding claims, **characterized in that**, on a first side (2a; 2a') and an opposite second side (2b; 2b') of the circuit board (2, 2'), in each case a frame element (5; 5') with a seal (6) surrounding the latter is arranged so as to border at least one electronic component (3), in each case the seal (6) being forced by a housing element (7a, 7b; 7a', 7b') against the circuit board (2; 2') in such a way that a first and a second electronics space (8) sealed off in a media-tight manner are formed.

10. Control device assembly (1; 1') according to one of the preceding claims, **characterized in that** at least one tab (15) for permanent connection to a further housing element (7b, 7a; 7b', 7a') is arranged on a housing element (7a, 7b; 7a', 7b') of the control device assembly (1; 1').

## Revendications

1. Module d'appareil de commande (1 ; 1'), en particulier pour un véhicule automobile, comprenant une carte à circuits imprimés (2 ; 2') recevant l'électronique de l'appareil de commande, **caractérisé en ce qu'**au moins un élément de cadre (5 ; 5') formé de manière autonome et enveloppant au moins un composant électronique (3) est supporté sur un côté équipé (2a ; 2a' ; 2b ; 2b') de la carte à circuits imprimés (2 ; 2'), un joint d'étanchéité (6) entourant l'élément de cadre (5 ; 5') s'appliquant contre une surface périphérique extérieure (5a ; 5a') dudit élément de cadre, et le joint d'étanchéité (6) étant repoussé par un élément de boîtier (7a, 7b ; 7a', 7b') pour former un espace électronique (8) étanche aux fluides contre la carte à circuits imprimés (2 ; 2').

2. Module d'appareil de commande (1 ; 1') selon la revendication 1, **caractérisé en ce que** l'élément de cadre (5 ; 5') est formé séparément de l'élément de boîtier (7a, 7b ; 7a', 7b'), lequel est notamment une partie supérieure de boîtier (7a ; 7a') ou une partie inférieure de boîtier (7b ; 7b'), et de la carte à circuits imprimés (2 ; 2').

3. Module d'appareil de commande (1) selon l'une quelconque des revendications précédentes, **caractérisé en ce que** l'élément de cadre (5) est disposé de manière permanente sur la carte à circuits imprimés (2), notamment est enfiché dans la carte à circuits imprimés (2).

4. Module d'appareil de commande (1 ; 1') selon l'une quelconque des revendications précédentes, **caractérisé en ce que** l'élément de cadre (5 ; 5') est fabriqué en plastique ou en tôle.

5. Module d'appareil de commande (1') selon l'une quelconque des revendications précédentes, **caractérisé en ce que** l'élément de cadre (5') est fixé de manière permanente à l'élément de boîtier (7a', 7b'), en particulier est inséré dans celui-ci.

6. Module d'appareil de commande (1 ; 1') selon l'une quelconque des revendications précédentes, **caractérisé en ce que** l'élément de boîtier (7a, 7b ; 7a', 7b') est formé en forme de plaque, notamment sous forme de plaque plane.

7. Module d'appareil de commande (1') selon l'une quelconque des revendications précédentes, **caractérisé en ce que** la carte à circuits imprimés (2') est connectée de manière thermoconductrice à l'élément de cadre (5'), et l'élément de cadre (5') est connecté de manière thermoconductrice à l'élément de boîtier (7a', 7b').

8. Module d'appareil de commande (1) selon l'une quelconque des revendications précédentes, **caractérisé en ce que** le profil de l'élément de cadre (5, 5') entre la carte à circuits imprimés (2 ; 2') et l'élément de boîtier (7a, 7b ; 7a', 7b') est rectangulaire.

9. Module d'appareil de commande (1) selon l'une quelconque des revendications précédentes, **caractérisé en ce qu'**au niveau d'un premier côté (2a ; 2a') et d'un deuxième côté opposé (2b ; 2b') de la carte à circuits imprimés (2 ; 2') est disposé à chaque fois un élément de cadre (5 ; 5') enveloppant au moins un composant électronique (3) avec un joint d'étanchéité (6) entourant l'élément de cadre, le joint d'étanchéité (6) étant à chaque fois repoussé par un élément de boîtier (7a, 7b ; 7a', 7b') contre la carte à circuits imprimés (2 ; 2') de telle sorte qu'il se forme un premier et un deuxième espace électronique (8) étanche aux fluides.

10. Module d'appareil de commande (1 ; 1') selon l'une quelconque des revendications précédentes, **caractérisé en ce qu'**au moins une patte (15) pour la connexion permanente à un élément de boîtier supplémentaire (7b, 7a ; 7b', 7a') est disposée au niveau d'un élément de boîtier (7a, 7b ; 7a', 7b') du module d'appareil de commande (1 ; 1').
